# EUROPEAN PATENT SPECIFICATION

(11) **EP 2 773 792 B1**
(45) Date of publication and mention of the grant of the patent: **14.06.2017**
(21) Application number: 12866275.6
(22) Date of filing: 02.11.2012
(51) Int. Cl.: C23C 14/35

(54) **LINEAR SCANNING SPUTTERING METHOD**
SPUTTERVERFAHREN MIT LINEARER ABTASTUNG
PROCÉDÉ DE PULVÉRISATION CATHODIQUE À BALAYAGE LINÉAIRE

(30) Priority: 04.11.2011 US 201161556154 P
(43) Date of publication of application: 10.09.2014
(73) Proprietor: Intevac, Inc., Santa Clara, CA 95054 (US)
(72) Inventor: BROWN, David, Ward, Pleasanton, CA 94566 (US); SHAH, Vinay, San Mateo, CA 94403 (US); PEDERSON, Terry, Sunnyvale, CA 94087 (US); BLUCK, Terry, Santa Clara, CA 95051 (US)
(74) Representative: Puschmann Borchert Bardehle Patentanwälte Partnerschaft mbB
(86) International application number: PCT/US2012/063432
(87) International publication number: WO 2013/109333

(56) References cited:
- WO-A1-2011/058812
- DE-A1- 19 701 575
- JP-A- H0 718 435
- US-A- 5 873 989
- US-A1- 2005 145 478
- US-A1- 2009 127 098
- US-A1- 2009 139 854
- US-A1- 2011 266 141

## Description

This application related a sputtering method, such as a sputtering method used to deposit thin films on substrates during the fabrication of integrated circuits, solar cells, flat panel displays, etc.

DE 197 01 575 A1 discloses that a magnetron sputtering is performed by disposing a sputtering target on the surface of a cubic-shape cathode capable of trapping magnetic field by magnets; applying negative potential to the target in a vacuum; sputtering the target by produced plasma; and coating the matrix surface with a coating while the matrix is travelling in right angle direction to the longitudinal direction of the cathode. The magnets of the cathode are arranged in such manner that sputtering erosion region can form two closed curves, and are allowed to move reciprocally in right angle direction to the longitudinal direction of the cathode.

JP H07 18435 A tries to improve the efficiency in utilizing a target and to stabilize the film forming rate and film characteristic by reciprocating a magnetic circuit at a constant speed along the traveling direction of a substrate on the rear of target and correspondingly controlling a discharge power. For this purpose, a target provided with a magnetron magnetic circuit on its rear is arranged in a sputtering chamber, and a DC electric field is impressed from a DC power source to produce plasma close to the target surface. The target is sputtered by the plasma to continuously form a thin film on a substrate continuously traveled by a carrier in opposition to the target. In this in-line magnetron sputtering method, the circuit is reciprocated at a constant speed along the traveling direction of the substrate by a moving device consisting of a moving mechanism and a motor. A discharge power to be impressed on the target is controlled through a controller in accordance with the moving direction of the circuit, and the film forming rate is kept constant on the substrate.

An example of a sputtering system having a linear scan magnetron is also disclosed in US-A-5,873,989. One of the problems to be resolved in such a system is the uniformity of the firm that is formed on the substrate. Another problem to be resolved in such a system is target utilization. Specifically, since the magnets of linear magnetrons scans back and forth, excessive sputtering occurs at both edges of the target, generating two deep grooves along, i.e., parallel to, the scan direction. Consequently, the target has to be replaced, even though the majority of the surface of the target is still usable. Various methods for combating this phenomenon are disclosed in US-A- 5,873,989.

However, another target utilization issue that has not been previously addressed is the erosion caused at the edges of the scan cycle. That is, when the magnets reach an end of the target, the scan direction is reversed. In order to achieve film uniformity, the US-A- 5,873,989 suggests to slow the scan speed towards either end of the target. However, this leads to increased sputtering of the target, leading to excessive erosion at both ends of the target in a direction perpendicular to the scan direction.

Accordingly, there is a need in the art for a sputtering method that enables uniform film deposition and increased target utilization.

For this purpose, the method of the invention comprises the features of claim 1.

Preferred embodiments of the invention are characterized in the sub-claims.

Disclosed herein is a sputtering method that enhances uniformity of the film formed on the substrate, and also enables high throughput. The magnetron is linearly scanned back and forth at speed that is at least several times higher than the speed on the substrates' motion. The magnetron is scanned in the direction of substrate travel and then in the reverse direction repeatedly. The turning point of the magnetron is changed at successive scans, so as to define a zone of turnaround. This also helps in enhancing target utilization.

The accompanying drawings, which are incorporated in and constitute a part of this specification, exemplify the embodiments of the present invention and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements, and are not drawn to scale.
- Figure 1: illustrates part of a system for processing substrate using sputtering the method according to one embodiment.
- Figure 2: illustrates a cross section along lines A-A in Figure 1.
- Figure 3: illustrates a cross section along lines B-B in Figure 1.
- Figure 4: illustrates another embodiment, wherein substrates are supported on a conveyor that moves continuously at constant speed.
- Figure 5: illustrates an example of a system architecture using a sputtering chamber such as that shown in Figure 4.
- Figure 6: illustrates an embodiment of a movable magnetron, which may be used in any of the disclosed embodiments.
- Figures 7A-7D: are plots of deposition uniformity using constant wafer transport speed and different magnets scan speed.
- Figure 8A: is a plot illustrating that the uniformity drops as the magnet scan speed increases.
- Figure 8B: is another pot illustrating a strange behavior of film deposition uniformity versus magnet scan speed at higher speed than the scan speed.
- Figure 8C: is an enlargement of the portion circled in Figure 8B.

Embodiments of the inventive sputtering system will now be described with reference to the drawings. Different embodiments may be used for processing different substrates of to achieve different benefits, such as throughput, firm uniformity, target utilization, etc. Depending on the outcome sought to be achieved, different features disclosed herein may be utilized partially or to their fullest, alone or in combination, balancing advantages with requirements and constraints. Therefore, certain benefits will be highlighted with reference to different embodiments, but are not limited to the disclosed embodiments.

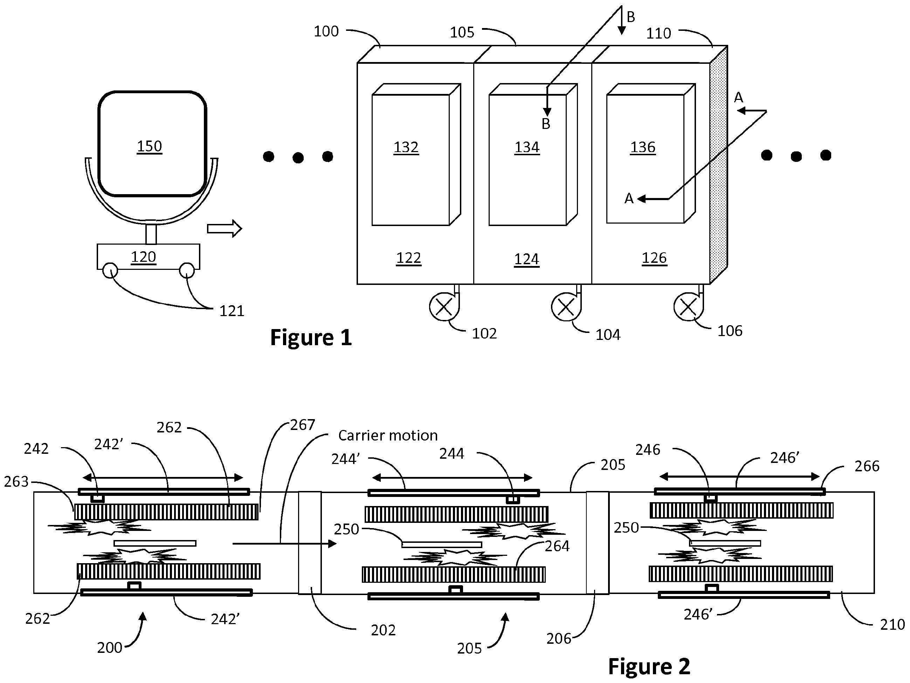

Figure 1 illustrates part of a system for processing substrates using sputtering magnetron, according to one embodiment. In Figure 1, three chambers, 100, 105 and 110, are shown, but the three dots on each side indicates that any number of chambers may be used. Also, while here three specific chambers are shown, it is not necessary that the chamber arrangement shown here would be employed. Rather, other chamber arrangements may be used and other type of chambers may be interposed between the chambers as shown. For example, the first chamber, 100, may be a loadlock, the second, 105, a sputtering chamber, and the third, 110 another loadlock.

For illustration purposes, in the example of Figure 1, the three chambers 100, 105 and 110 are sputtering chambers; each evacuated by its own vacuum pump 102, 104, 106. Each of the processing chambers has a transfer section, 122, 124 and 126, and a processing section 132, 134 and 136. Substrate 150 is mounted onto a substrate carrier 120. In this embodiment, the substrate 150 is held by its periphery, i.e., without touching any of its surfaces, as both surfaces are fabricated by sputtering target material on both sides of the substrate. The carrier 120 has a set of wheels 121 that ride on tracks (not shown in Figure 1). In one embodiment, the wheels are magnetized so as to provide better traction and stability. The carrier 120 rides on rails provided in the transfer sections so as to position the substrate in the processing section. In one embodiment, motive force is provided externally to the carrier 120 using linear motor arrangement (not shown in Figure 1). When the three chambers 100, 105, and 110, are sputtering chambers, it is assumed that the carrier 120 enters and exits the system via a loadlock arrangement.

Figure 2 illustrates a cross section along lines A-A in Figure 1. For simplicity, in Figure 2 substrate 250 is illustrated without its carrier, but it should be appreciated that the substrate 250 remains on the substrate carrier 120 throughout the processing performed in the system of Figure 1, and is continuously transported from chamber to chamber by the substrate carrier, as illustrated by the arrow in Figure 2. In this illustrative embodiment, in each chamber, 200, 205 and 210, the substrate 250 is processed on both sides. Also shown in Figure 2 are isolation valves 202, 206, that isolate each chamber during fabrication; however, since in one embodiment the substrates continuously move, the isolation valves can be replaced with simple gates or eliminated.

Each chamber includes a movable magnetron 242, 244, 246, mounted onto a linear track 242', 244', 246', such that it scans the plasma over the surface of the target 262, as shown by the double-headed arrows. The magnets are scan back and forth continuously as the substrates are transported in the chambers on the carriers. As illustrated with respect to magnets 242, as the magnets reach the leading edge 243 of the target 262, it reverses direction and travels towards the trailing edge 247 of target 262. When it reaches the trailing edge 247, it again reverses direction and is scanned towards the leading edge 243. This scanning process is repeated continuously.

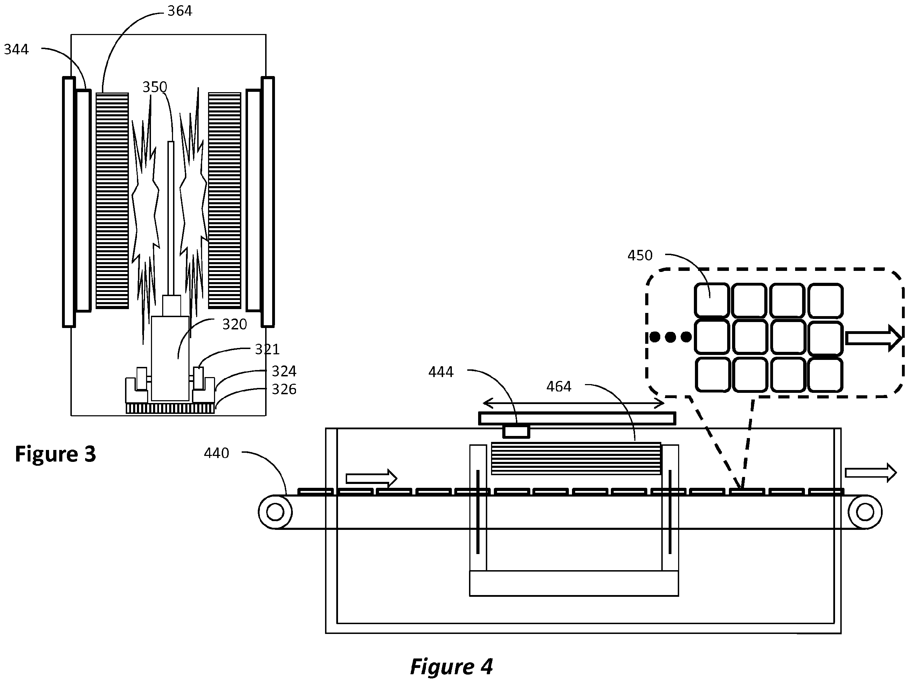

Figure 3 illustrates a cross section along lines B-B in Figure 1. Substrate 350 is shown mounted onto carrier 320. Carrier 320 has wheels 321, which ride on tracks 324. The wheels 321 may be magnetic, in which case the tracks 324 may be made of paramagnetic material. In this embodiment the carrier is moved by linear motor 326, although other motive forces and/or arrangements may be used. The chamber is evacuated and precursor gas, e.g., argon, is supplied into the chamber to maintain plasma. Plasma is ignited and maintained by applying RF bias energy to the movable magnetron 344, situated behind target 364.

Figure 4 illustrates another embodiment, wherein substrates 450 are supported on a conveyor 440 that moves continuously for "pass-by" processing. This arrangement is particularly beneficial when only one side of the substrates needs to be sputtered, such as when fabricating solar cells. For example, several substrates can be positioned abreast such that several are processed simultaneously. The callout in Figure 4 illustrates three substrates abreast, i.e., arrange perpendicularly to the direction of motions, as indicated by the arrow. In such an embodiment, when the target 464 is longer relative to the size of the substrates, then several substrates can be processed simultaneously in columns and rows as the belt continuously move the substrate under the target 464. For example, when using three rows, i.e., three wafers abreast, the size of the target can be designed so as to enable processing of four substrates in three rows, thus simultaneously processing twelve substrates. As before, the magnetron 444 moves back and forth linearly between the leading and trailing edges of the target, as shown by the double-headed arrow.

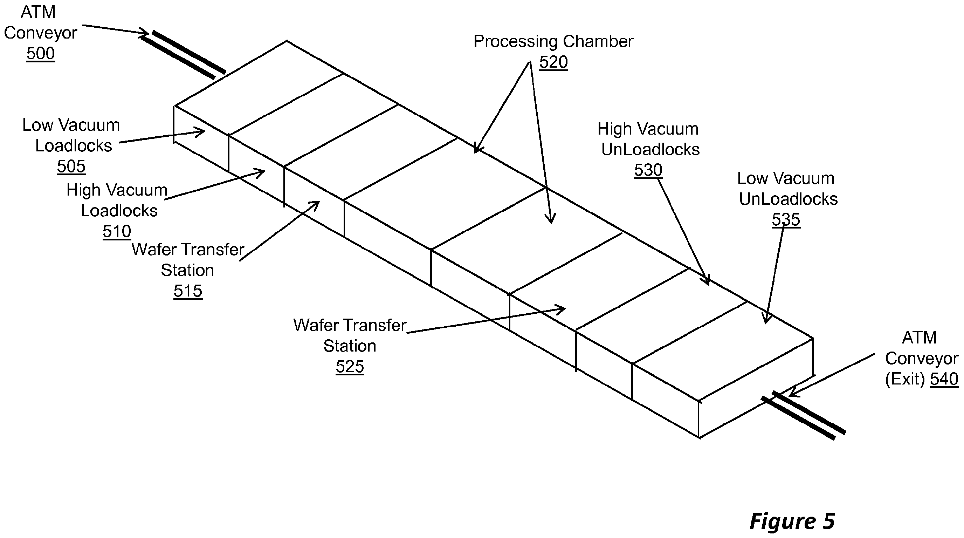

Figure 5 illustrates an example of a system such as that shown in Figure 4. An atmospheric conveyor 500 continuously brings substrates into the system, and the substrates are then transported on conveyors inside the systems so as to traverse a low vacuum loadlock 505, a high vacuum loadlock 510, and, optionally, a transfer chamber 515. Then the substrates, while continuously moving on conveyor, are processed by one or more successive chambers 520, here two are shown. The substrates then continue on conveyors to an optional transfer chamber 525, then to high vacuum loadlock 530, low vacuum loadlock 535, and then to atmospheric conveyor 540, to exit the system.

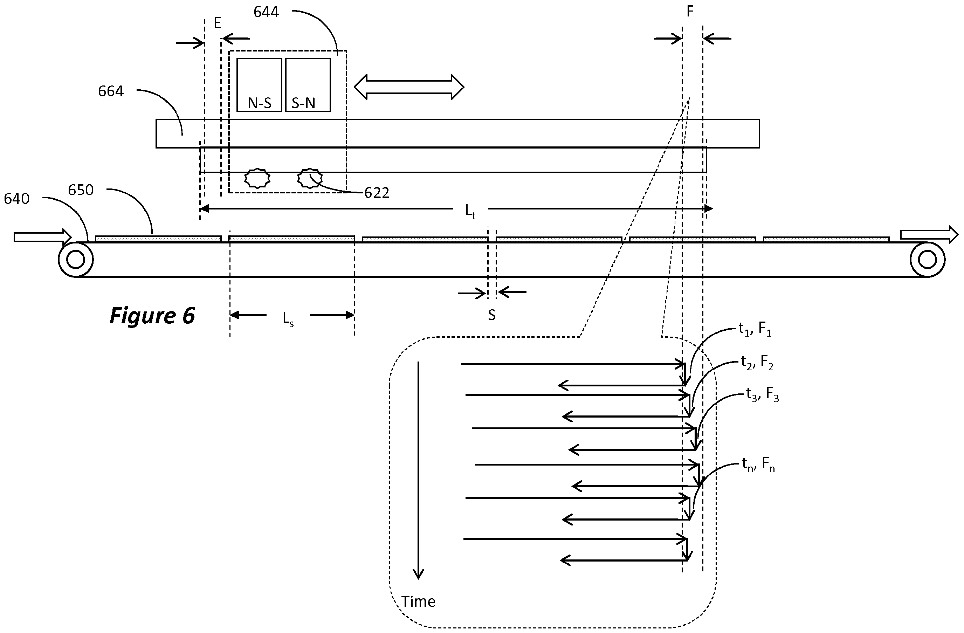

Figure 6 illustrates an embodiment of the movable magnetron, which may be used in any of the above embodiments. In Figure 6, the substrates 650 are moved on the conveyor 640 at constant speed. The target assembly 664 is positioned above the substrates, and movable magnetron 644 oscillates back and forth linearly behind the target assembly, as sown by the double-headed arrow. The plasma 622 follows the magnetron, causing sputtering from different areas of the target. In this embodiment, during normal travel the speed of the magnetron is constant and is at least several times the speed of the substrates. The speed is calculated such that during the time a substrate traverses the sputtering chamber, it is sputtered several times by the moving magnetron. For example, the speed of the magnetron can be five to ten times faster than the speed of the substrate, such that by the time the conveyor moves the substrate past the entire length of the target, the magnets have been scanned back and forth several times behind the target so as to deposit multiple layers on the substrate.

As shown in Figure 6, in this embodiment each substrate is of length Ls, which is defined in the direction of travel of the conveyor belt. Similarly, the target has a length Lt, which is defined in the direction of travel of the conveyor, which is parallel with the direction of travel of the magnets. In this embodiment, the target's length, Lt, is several times longer than the substrate length Ls. For example, the target length can be four times longer than the pitch length, which is defined as one substrate length plus the length of separation S between two substrates on the conveyor. That is, the pitch P = (Ls + S).

The problem with linear motion of magnetron behind a target is that when it reaches the leading or trailing end of the target, it stops and starts motion in the reverse direction. Consequently, the edges of the target get eroded much more than the main surface of the target. When the erosion at the edges of the target exceed specification, the target needs to be replaced, even though the center of the target is still usable. This problem is addressed using various embodiments, as described below.

According to one embodiment, offsets E and F are designated at the leading and trailing edges of the target, respectively. When the magnetron reaches the offset, it decelerates at a prescribed rate, e.g., 0.5g, 1g, etc. At the end of the offset the magnetron changes direction and accelerates at the prescribed rate. This is done at both ends of travel of the magnetron, i.e., at the leading and trailing edges of the target.

According to another embodiment, a rotation zone is prescribed, e.g., zones E and F are designated at the leading and trailing edges of the target, respectively. When the magnetron reaches either of the rotation zones, it changes travel direction at a point within the rotating zone. However, over time the magnetron changes direction at a different points within the rotating zone. This is exemplified by the callout in Figure 6. As illustrated, at time t₁ the point of reversing direction is designated as F₁. At time t₂, the point of reversing direction is designated F₂, and is further towards the trailing edge of the target as point F₁, but is still within the zone designated F. At time t₃, the point of reversing direction F₃ is even further towards the trailing edge of the target, while at time tₙ, point Fₙ is back away from the trailing edge of the target. However, all points Fᵢ are within the zone F. A similar process takes place over zone E on the other side, i.e., the leading edge of the target.

The selection of the points of reversing scan direction can be done using various ways. For example, a random selection can be done at each scan, at each two scans, or after x number of scans. Conversely, a program can be implemented wherein at each scan the point is moved a distance Y in one direction until the end of the zone is reached, and then the points start to move a distance Y towards the opposite end. On the other hand, the movement can be designed to generate an interlaced pattern by moving in one direction a Z amount and then in the next step moving in the reverse direction a -w amount, wherein |w| < |Z|.

In the embodiments described herein, over the processing regime the magnetron is scanned at constant speed, as it has been found that varying the scan speed adversely affects film uniformity on the substrates. Notably, in configurations where the substrates continuously moves in front of the target, slowing down or speeding up the magnet array over the processing area is unadvisable, even for controlling the film thickness uniformity.

In the disclosed embodiments, moving many substrates on a conveyor can be thought of as a continuous (infinitely long) substrate that is moving at a constant speed. The scan speed must be selected so as to give good uniformity on a substrate moving at a constant speed. In these embodiments, special use is made of the start position, the stop position, acceleration, and deceleration to control target utilization. This has the effect of spreading out the deep grooves that occur at the ends when reversing the motion.

A pole design is used to reduce the deep grooves at the top and bottom of the plasma track. A thicker target can be used or higher power can be utilized into the targets because the scan is done at a fairly high speed, spreading the power out over the full surface of the substrate. Because each substrate sees multiple target passes of the plasma, the start and stop position can be varied with each pass and the effect of changing the scan length from one pass to the next will not be seen in the film uniformity. That is, while the embodiment of Figure 6 was described such that the rotating zone is designed to be outside of the processing area, this is not necessary when having the substrates continuously move, as described herein. Rather, the rotating zone can be within the processing area.

For example, according to one embodiment the system is used to fabricate solar cells at a rate of 2400 substrates per hour. The conveyor continuously moves the substrates at a rate of about 35mm/sec. The magnetron is scanned at a speed of at least 250 mm/sec, i.e., more than seven times the speed of the substrate transport. The target and magnetron are designed such that the stroke of the magnetron scan is about 260mm. This provides film uniformity of over 97%. The acceleration/deceleration can be set at 0.5g with a distance of about 6.4mm or 1g, for about half that distance.

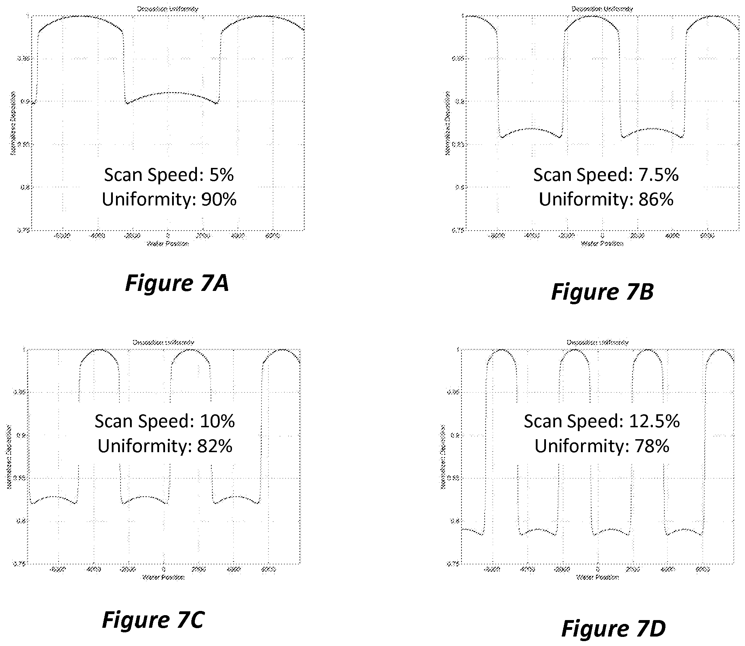

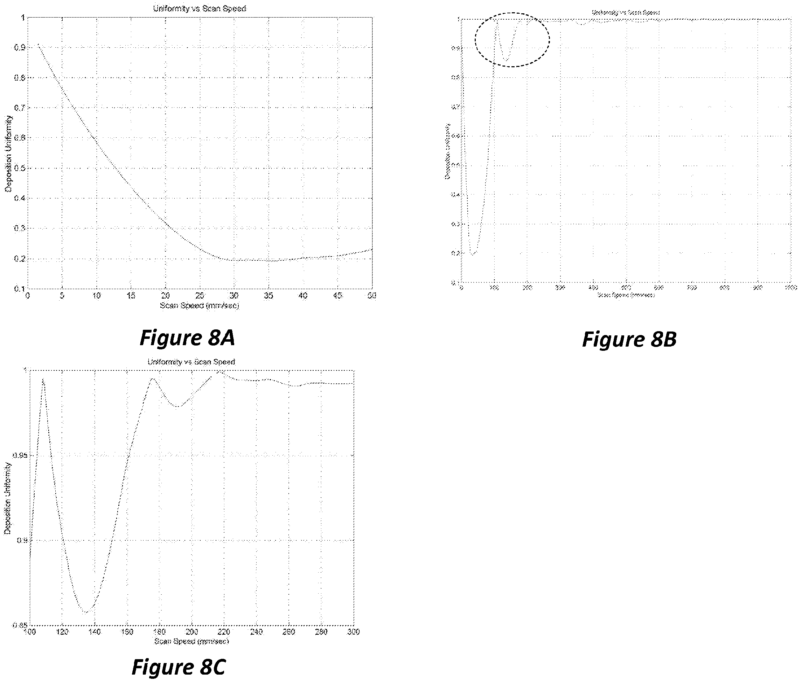

Figures 7A-7D are plots of deposition uniformity using constant wafer transport speed and different magnets scan speed. Figure 7A is a plot of uniformity for magnets scan speed that is 5% of the wafer transport speed. For example, for a wafer transport speed of 35mm/s, the magnets were scan at 1.75mm/s. The resulting film uniformity was 90%, which is not adequate for production of devices such as solar cells. When the magnet scan speed was increased to 7.5% of the wafer speed, the uniformity dropped to 86%, as shown in Figure 7B. Moreover, as the speed was increased to 10% the uniformity dropped to 82%, and when the sped was increased to 12.5% the uniformity dropped even further to 78%. Thus, it appeared that increasing the magnet scan speed causes a corresponding reduction of film uniformity, suggesting that the magnet scan speed should be a small fraction of the wafer transport speed. This conclusion was further supported by the plot shown in Figure 8A, wherein uniformity drops as the magnet scan speed increases.

However, the plot of Figure 8A also shows that the maximum achievable uniformity may be about 90% or so. As noted above, such uniformity is not acceptable for many processes. Therefore, further investigation was undertaken, resulting in the plot of Figure 8B. The plot of Figure 8B illustrates a strange behavior of film deposition uniformity versus magnet scan speed. Indeed, as magnet scan speed increases, film uniformity drops. However, at a certain point, as the magnet scan speed increases further, uniformity suddenly starts to improve, such that at about magnet scan speed that is three times the wafer transport speed, a uniformity peak of about 98% is achieved. Thereafter a short drop in uniformity is observed, but then uniformity is recovered and remains high when the magnet scan speed that is about 5 times the wafer transport speed and beyond, which is illustrated in the plot of Figure 8C. As shown in Figure 8C, which is an enlargement of the portion circled in Figure 8B, at speeds beyond 5 times the wafer transport speed, the uniformity remains above 97% and, at speeds of about 10 times the transport speed the uniformity remains at over 98%. Higher speeds are not recommended from the mechanical load and machine design perspective, and the uniformity does not seem to improve that much for higher speeds. Thus, the cost in design complexity and potential higher maintenance may not warrant going to scan speeds beyond 10 times the wafer transport speed.

It should be understood that processes and techniques described herein are not inherently related to any particular apparatus and may be implemented by any suitable combination of components. Further, various types of general purpose devices may be used in accordance with the teachings described herein. The present invention has been described in relation to particular examples, which are intended in all respects to be illustrative rather than restrictive. Those skilled in the art will appreciate that many different combinations will be suitable for practicing the present invention.

Moreover, other implementations of the invention will be apparent to those skilled in the art from consideration of the specification and practice of the invention disclosed herein.

## Claims

1. A method for processing substrate by sputtering, comprising:
placing plurality of substrates on a conveyor;
operating the conveyor to transport the plurality of substrates at a constant speed and in an orientation facing a target, such that at any given time, several substrates face the target between the leading edge and the trailing edge;
reciprocally scanning a magnet arrangement behind the target while sustaining plasma in a space between the target and the substrates, wherein the step of reciprocally scanning the magnet arrangement is performed at a speed that is at least several times faster than the constant speed of the conveyor,
**characterized by**
defining rotating zones behind leading edge and trailing edge of the target, and reversing the reciprocal scanning of the magnet arrangement at different points within the rotating zones during different scans.

2. The method of claim 1, wherein the magnet arrangement slide speed is at least five times the constant speed of the substrate transport.

3. The method of claim 1, further comprising decelerating the magnet arrangement when it enters the rotating zones and accelerating the magnet arrangement as it reverses direction of sliding within the rotating zone.

4. The method of claim 1, wherein the magnet arrangement reverses direction of sliding at randomly selected points within the rotating zone at different scans.

5. The method of claim 1, wherein each substrate has a length Ls defined in the direction of travel, and wherein the target has a length Lt defined in the direction of substrate travel, and wherein the target length Lt is several times longer than the substrate length Ls.

6. The method of claim 1, wherein each substrate has a length Ls defined in the direction of travel, and separated a length S from a neighboring substrate, wherein pitch length is defined as (Ls + S), and wherein the target has a length Lt defined in the direction of substrate travel, and wherein the target length Lt is at least four times the pitch length.

## Patentansprüche

1. Verfahren zur Substratbehandlung durch Sputtern, welches folgendes umfasst:
Platzieren einer Vielzahl von Substraten auf einen Förderer;
Betreiben des Förderers zum Transport der Vielzahl von Substraten mit konstanter Geschwindigkeit und in einer einem Target zugewandten Ausrichtung, so dass zu jeder gegebenen Zeit mehrere Substrate dem Target zwischen dessen Vorderkante und
Hinterkante zugewandt sind;
wechselseitiges Abtasten einer hinter dem Target befindlichen Magnetanordnung unter gleichzeitigem Erhalt von Plasma in einem Raum zwischen dem Target und den Substraten, wobei der Schritt des wechselseitigen Abtastens der Magnetanordnung mit einer Geschwindigkeit erfolgt, die mindestens um ein Mehrfaches höher ist als die konstante Geschwindigkeit des Förderers,
**gekennzeichnet durch**
das Definieren von Rotationszonen hinter der Vorderkante und der Hinterkante des Targets, und Umkehren des wechselseitigen Abtastens der Magnetanordnung an verschiedenen Punkten innerhalb der Rotationszonen während verschiedener Abtastvorgänge.

2. Verfahren nach Anspruch 1, bei dem die Gleitgeschwindigkeit der Magnetanordnung mindestens ein Fünffaches der konstanten Geschwindigkeit des Substrattransports beträgt.

3. Verfahren nach Anspruch 1, des Weiteren umfassend ein Verlangsamen der Magnetanordnung bei deren Eintritt in die Rotationszonen und ein Beschleunigen der Magnetanordnung bei Gleitrichtungswechsel innerhalb der Rotationszone.

4. Verfahren nach Anspruch 1, bei dem die Magnetanordnung an beliebig ausgewählten Punkten innerhalb der Rotationszone zu unterschiedlichen Abtastvorgängen ihre Gleitrichtung wechselt.

5. Verfahren nach Anspruch 1, bei dem jedes Substrat eine in der Verlaufsrichtung definierte Länge Ls hat und bei dem das Target eine in der Länge der Substratverlaufsrichtung definierte Länge Lt hat und bei dem die Targetlänge Lt um ein Mehrfaches länger als die Substratlänge Lt ist.

6. Verfahren nach Anspruch 1, bei dem jedes Substrat eine in der Verlaufsrichtung definierte Länge Ls hat und um eine Länge S von einem benachbarten Substrat getrennt ist, wobei die Abstandslänge definiert ist als (Ls + S), und bei dem das Target eine in der Richtung des Substratverlaufs definierte Länge Lt hat und wobei die Targetlänge Lt mindestens ein Vierfaches der Abstandslänge beträgt.

## Revendications

1. Procédé de traitement de substrat par pulvérisation cathodique, comprenant les étapes consistant à :
placer une pluralité de substrats sur un transporteur ;
actionner le transporteur pour transporter la pluralité de substrats à une vitesse constante et dans une orientation face à une cible, de manière qu'à tout moment, plusieurs substrats soient situés en regard de la cible entre le bord avant et le bord arrière ;
balayer en va-et-vient un agencement d'aimants derrière la cible, tout en maintenant le plasma dans un espace compris entre la cible et les substrats, dans lequel l'étape de balayage en va-et-vient de l'agencement d'aimants est effectuée à une vitesse qui est au moins plusieurs fois supérieure à la vitesse constante du transporteur,
**caractérisé par ;**
la définition de zones de rotation derrière le bord avant et le bord arrière de la cible, et
l'inversion du balayage en va-et-vient de l'agencement d'aimants à différents points à l'intérieur des zones de rotation au cours de différents balayages.

2. Procédé selon la revendication 1, dans lequel la vitesse de coulissement de l'agencement d'aimants est au moins cinq fois supérieure à la vitesse constante de transport de substrats.

3. Procédé selon la revendication 1, comprenant en outre le ralentissement de l'agencement d'aimants lorsqu'il entre dans les zones de rotation et l'accélération de l'agencement d'aimants tandis qu'il inverse le sens de coulissement à l'intérieur des zones de rotation.

4. Procédé selon la revendication 1, dans lequel l'agencement d'aimants inverse le sens de coulissement à des points choisis au hasard à l'intérieur de la zone de rotation lors de différents balayages.

5. Procédé selon la revendication 1, dans lequel chaque substrat a une longueur Ls définie dans le sens de déplacement, et dans lequel la cible a une longueur Lt définie dans le sens de déplacement de substrat, et dans lequel la longueur de cible Lt est plusieurs fois supérieure à la longueur de substrat Ls.

6. Procédé selon la revendication 1, dans lequel chaque substrat a une longueur Ls définie dans le sens de déplacement, et est séparé d'un substrat voisin par une longueur S, dans lequel une longueur de pas est définie comme étant égale à (Ls + S), et dans lequel la cible a une longueur Lt définie dans le sens de déplacement de substrat, et dans lequel la longueur de cible Lt est au moins quatre fois supérieure à la longueur de pas.
